# EUROPEAN PATENT APPLICATION

(11) **EP 4 814 158 A1**
(43) Date of publication of application: **30.09.2026**
(21) Application number: 26164876.0
(22) Date of filing: 16.03.2026
(51) Int. Cl.: C23C 16/02, C23C 16/34, C23C 16/40, C23C 16/455

(54) **PROCESSING METHOD, METHOD OF MANUFACTURING SEMICONDUCTOR DEVICE, PROGRAM, AND PROCESSING APPARATUS**

(30) Priority: 28.03.2025 JP 2025057224
(71) Applicant: Kokusai Electric Corporation, Tokyo 100-0004 (JP)
(72) Inventor: YAMAGUCHI, Tatsuya, Toyama-shi, Toyama, 939-2393 (JP)
(74) Representative: Bardehle Pagenberg Partnerschaft mbB Patentanwälte Rechtsanwälte

(57) **Abstract**

A technique that includes: a first process of modifying a predetermined surface of a material, by performing a first operation including: (a1) supplying a precursor gas containing a first predetermined element and a halogen element to the material including the predetermined surface; (a2) after (a1), supplying a first modifying gas containing oxygen to the material; and (a3) after (a1), supplying a second modifying gas, which is different from the first modifying gas, to the material; and a second process of forming a film containing the first predetermined element on the modified predetermined surface after the first process, by performing a second operation a predetermined number of times, the second operation including: (b1) supplying the precursor gas to the material; and (b2) supplying a reaction gas to the material.

## Description

### CROSS-REFERENCE TO RELATED APPLICATION

This application is based upon and claims the benefit of priority from Japanese Patent Application No. 2025-057224, filed on March 28, 2025, the entire contents of which are incorporated herein by reference.

### TECHNICAL FIELD

The present disclosure relates to a processing method, a method of manufacturing a semiconductor device, a program, and a processing apparatus.

### BACKGROUND

In the related art, as a substrate processing process (a process of manufacturing a semiconductor device), a process of supplying a precursor gas, which contains a halogen element, and a reaction gas to a substrate may be performed to form a film on the substrate.

### SUMMARY

Some embodiments of the present disclosure provide a technique capable of improving coverage of a formed film.

According to some embodiments of the present disclosure, there is provided a technique that includes: a first process of modifying a predetermined surface of a material, by performing a first operation including: (a1) supplying a precursor gas containing a first predetermined element and a halogen element to the material including the predetermined surface; (a2) after (a1), supplying a first modifying gas containing oxygen to the material; and (a3) after (a1), supplying a second modifying gas, which is different from the first modifying gas, to the material; and a second process of forming a film containing the first predetermined element on the modified predetermined surface after the first process, by performing a second operation a predetermined number of times, the second operation including: (b1) supplying the precursor gas to the material; and (b2) supplying a reaction gas to the material.

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view schematically illustrating a substrate processing apparatus.
FIG. 2 is a schematic diagram illustrating a configuration of a controller of a substrate processing apparatus, in which a control system of the controller is shown in a block diagram.
FIG. 3 is a flowchart of a substrate processing process.

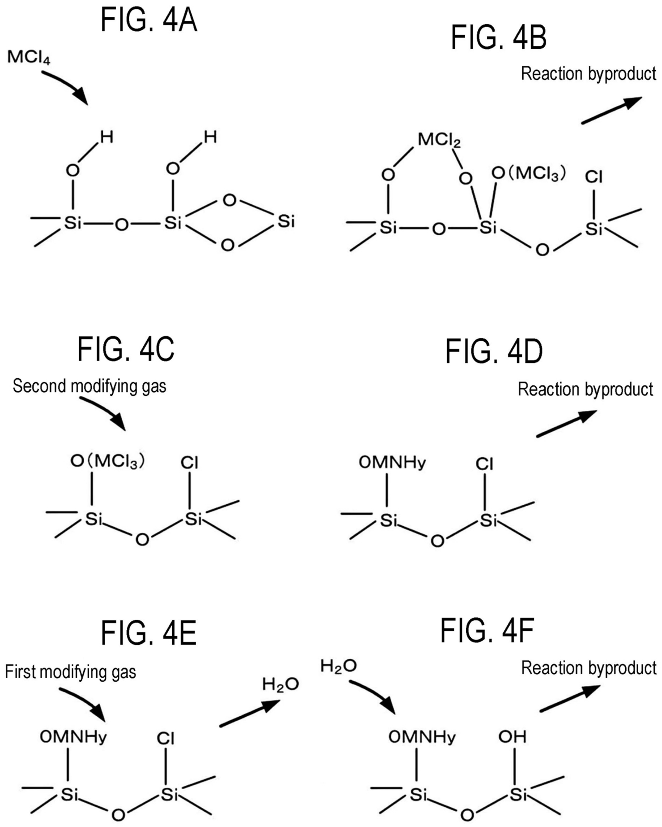

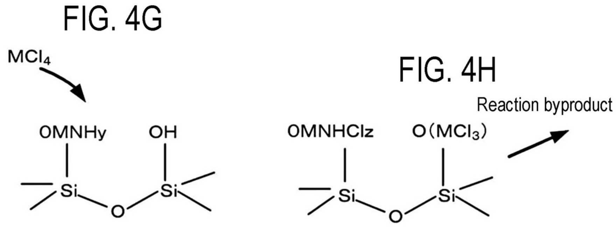

FIG. 4A is a diagram illustrating a surface state of a substrate when supplying a precursor gas. FIG. 4B is a diagram illustrating a surface state of the substrate after supplying the precursor gas. FIG. 4C is a diagram illustrating a surface state of the substrate when supplying a second modifying gas. FIG. 4D is a diagram illustrating a surface state of the substrate after supplying the second modifying gas. FIG. 4E is a diagram illustrating a surface state of the substrate when supplying a first modifying gas. FIG. 4F is a diagram illustrating a surface state of the substrate after supplying the first modifying gas. FIG. 4G is a diagram illustrating a surface state of the substrate when supplying the precursor gas. FIG. 4H is a diagram illustrating a surface state of the substrate after supplying the precursor gas.
FIG. 5 is a modification of a flowchart of a pre-process.
FIG. 6 is a modification of a flowchart of the pre-process.
FIG. 7A is a diagram illustrating a processing sequence when supplying a first modifying gas. FIG. 7B is a diagram illustrating a modification of the processing sequence when supplying the first modifying gas. FIG. 7C is a diagram illustrating a modification of the processing sequence when supplying the first modifying gas.
FIG. 8A is a diagram illustrating a modification of a processing sequence when supplying a precursor gas in a film formation process. FIG. 8B is a diagram illustrating a modification of the processing sequence when supplying the precursor gas in the film formation process. FIG. 8C is a diagram illustrating a modification of the processing sequence when supplying the precursor gas in the film formation process.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure embodiments of the various embodiments.

### <Embodiments of Present Disclosure>

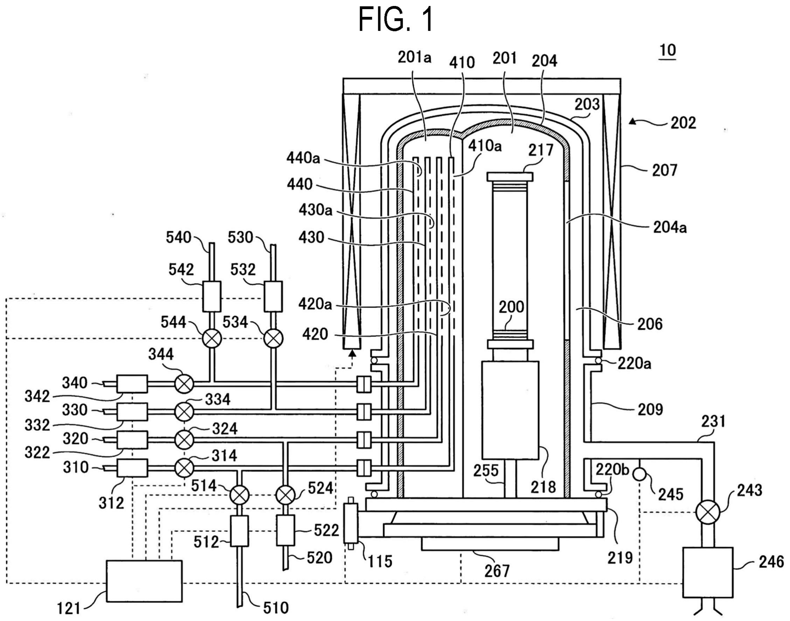

Hereinafter, some embodiments of the present disclosure will be described mainly with reference to FIGS. 1 to 8C. The drawings used in the following description are schematic, and dimensional relationships, ratios, and the like of various elements shown in the drawings may not match actual ones. Further, dimensional relationships, ratios, and the like of various elements among plural drawings may not match each other.

### (1) Configuration of Substrate Processing Apparatus

A substrate processing apparatus 10 as a processing apparatus includes a process furnace 202 provided with a heater 207 serving as a heating means or unit (a heating mechanism or a heating system). The heater 207 is formed in a cylindrical shape and is vertically installed by being supported by a heater base (not shown) serving as a holding plate.

An outer tube 203 constituting a process container is disposed inside the heater 207 to be concentric with the heater 207. The outer tube 203 is made of, for example, a heat resistant material such as quartz or silicon carbide (SiC) and is formed in a cylindrical shape with its upper end closed and its lower end opened. A manifold 209 (hereinafter referred to as a MF 209) is disposed to be concentric with the outer tube 203 below the outer tube 203. The MF 209 is made of, for example, metal such as stainless steel and is formed in a cylindrical shape with its upper and lower ends opened. An O-ring 220a serving as a seal is installed between the upper end of the MF 209 and the outer tube 203. The MF 209 is supported by a heater base, such that the outer tube 203 is vertically installed.

An inner tube 204 constituting the process container is disposed inside the outer tube 203. The inner tube 204 is made of, for example, a heat resistant material such as quartz or SiC and is formed in a cylindrical shape with its upper end closed and its lower end opened. The process container is mainly constituted by the outer tube 203, the inner tube 204, and the MF 209. A process chamber 201 is formed in a hollow cylindrical area of the process container (inside the inner tube 204).

The process chamber 201 is configured to be capable of accommodating wafers 200, serving as substrates, in such a state that the wafers 200 are arranged in a horizontal posture and in multiple stages along a vertical direction by a boat 217 described later.

Nozzles 410, 420, 430, and 440 are installed inside the process chamber 201 so as to penetrate a sidewall of the MF 209 and the inner tube 204. Gas supply pipes 310, 320, 330, and 340 are connected to the nozzles 410, 420, 430, and 440, respectively. However, the process furnace 202 of the embodiments is not limited to the above-described configuration.

Mass flow controllers (MFCs) 312, 322, 332, and 342, serving as flow rate controllers (flow rate control parts), and valves 314, 324, 334, and 344, serving as opening/closing valves, are installed at the gas supply pipes 310, 320, 330, and 340, respectively, sequentially from the upstream side of gas flow. Gas supply pipes 510, 520, 530, and 540 configured to supply an inert gas are connected to the gas supply pipes 310, 320, 330, and 340 at the downstream side of valves 314, 324, 334, and 344, respectively. MFCs 512, 522, 532, and 542 and valves 514, 524, 534, and 544 are installed at the gas supply pipes 510, 520, 530, and 540, respectively, sequentially from the upstream side.

The nozzles 410, 420, 430, and 440 are connected to front ends of the gas supply pipes 310, 320, 330, and 340, respectively. The nozzles 410, 420, 430, and 440 are constituted as L-shaped nozzles. Horizontal portions of the nozzles 410, 420, 430, and 440 are installed to penetrate the sidewall of the MF 209 and the inner tube 204. Vertical portions of the nozzles 410, 420, 430, and 440 are installed inside a channel-shaped (groove-shaped) preliminary chamber 201a formed to protrude outward of the inner tube 204 in a radial direction and extend along the vertical direction and extend upward along an inner wall of the inner tube 204 in the preliminary chamber 201a (upward in an arrangement direction of the wafers 200).

The nozzles 410, 420, 430, and 440 are installed to extend from a lower region to an upper region of the process chamber 201, and a plurality of gas supply holes 410a, 420a, 430a, and 440a are respectively formed at positions facing the wafers 200. Thereby, a process gas is supplied to the wafers 200 from the gas supply holes 410a, 420a, 430a, and 440a of the nozzles 410, 420, 430, and 440, respectively. The gas supply holes 410a, 420a, 430a, and 440a are formed in a plural number from a lower side to an upper side of the inner tube 204. Opening areas of the gas supply holes 410a, 420a, 430a, and 440a are the same and the gas supply holes 410a, 420a, 430a, and 440a are formed at the same opening pitch.

A precursor gas as the process gas is supplied from the gas supply pipe 310 into the process chamber 201 via the MFC 312, the valve 314, and the nozzle 410.

A reaction gas serving as the process gas is supplied from the gas supply pipe 320 into the process chamber 201 via the MFC 322, the valve 324, and the nozzle 420.

A first modifying gas serving as the process gas is supplied from the gas supply pipe 330 into the process chamber 201 via the MFC 332, the valve 334, and the nozzle 430.

A second modifying gas, which serves as a process gas and is different from the first modifying gas, is supplied from the gas supply pipe 340 into the process chamber 201 via the MFC 342, the valve 344, and the nozzle 440.

An inert gas is supplied from the gas supply pipes 510, 520, 530, and 540 into the process chamber 201 via the MFCs 512, 522, 532, and 542, the valves 514, 524, 534, and 544, and the nozzles 410, 420, 430, and 440, respectively.

Although a process gas supply system mainly includes the gas supply pipes 310, 320, 330, and 340, the MFCs 312, 322, 332, and 342, the valves 314, 324, 334, and 344, and the nozzles 410, 420, 430, and 440, the nozzles 410, 420, 430, and 440 may be considered as the processing gas supply system. The process gas supply system may be simply referred to as a gas supply system. In a case where the precursor gas flows from the gas supply pipe 310, although a precursor gas supply system mainly includes the gas supply pipe 310, the MFC 312, and the valve 314, the nozzle 410 may be considered to be included in the precursor gas supply system. Furthermore, in a case where the reaction gas flows from the gas supply pipe 320, although a reaction gas supply system mainly includes the gas supply pipe 320, the MFC 322, and the valve 324, the nozzle 420 may be considered to be included in the reaction gas supply system. In addition, in a case where the first modifying gas flows from the gas supply pipe 330, although a first modifying gas supply system mainly includes the gas supply pipe 330, the MFC 332, and the valve 334, the nozzle 430 may be considered to be included in the first modifying gas supply system. In a case where the second modifying gas flows from the gas supply pipe 340, although a second modifying gas supply system mainly includes the gas supply pipe 340, the MFC 342, and the valve 344, the nozzle 440 may be considered to be included in the second modifying gas supply system. Furthermore, an inert gas supply system mainly includes the gas supply pipes 510, 520, 530, and 540, the MFC 512, 522, 532, and 542, and the valves 514, 524, 534, and 544.

An exhaust hole (exhaust port) 204a is an opening formed on the sidewall of the inner tube 204 and at a position facing the nozzles 410, 420, 430, and 440. A shape of the opening is, for example, a slit shape. A gas, which is supplied from the gas supply holes 410a, 420a, 430a, and 440a of the nozzles 410, 420, 430, and 440 into the process chamber 201 and flows over the surface of the wafer 200, flows through an exhaust passage 206, which is constituted by a gap formed between the inner tube 204 and the outer tube 203, via the exhaust hole 204a. Then, the gas flowing through the exhaust passage 206 flows through an exhaust pipe 231 and is discharged to the outside of the process furnace 202.

The MF 209 is provided with the exhaust pipe 231 configured to exhaust an internal atmosphere of the process chamber 201. A pressure sensor 245 serving as a pressure detector (pressure detection part) configured to detect an internal pressure of the process chamber 201, an automatic pressure controller (APC) valve 243, and a pump 246 serving as an exhauster are connected to the exhaust pipe 231 sequentially from the upstream side. The APC valve 243 can exhaust the internal atmosphere of the process chamber 201 or stop the exhaust by being opened or closed while operating the pump 246. Further, the APC valve 243 can adjust the internal pressure of the process chamber 201 by adjusting a degree of valve opening while operating the pump 246. An exhaust system mainly includes the exhaust hole 204a, the exhaust passage 206, the exhaust pipe 231, the APC valve 243, and the pressure sensor 245. The pump 246 may be considered to be included in the exhaust system.

A seal cap 219 (hereinafter referred to as a SC 219), which serves as a furnace opening lid configured to be capable of hermetically sealing a lower end opening of the MF 209, is installed below the MF 209. An O-ring 220b, which serves as a seal in contact with a lower end of the MF 209, is installed on an upper surface of the SC 219. A rotator 267 configured to rotate the boat 217 accommodating the wafers 200 is installed on a side of the SC 219 opposite to the process chamber 201. A rotary shaft 255 of the rotator 267 is connected to the boat 217 by penetrating the SC 219. The SC 219 is configured to be vertically moved up or down by a boat elevator 115 (hereinafter referred to as a BE 115) serving as an elevator mechanism vertically installed outside the outer tube 203. The BE 115 is constituted as a transfer apparatus (transfer system) configured to transfer the boat 217 and the wafers 200 accommodated in the boat 217 into or out of the process chamber 201.

The boat 217 serving as a substrate support is configured to support a plurality of wafers 200, for example, 10 to 200 wafers, in such a state that the wafers 200 are arranged in horizontal posture while being spaced apart from each other in the vertical direction. The boat 217 is made of, for example, a heat resistant material such as quartz or SiC. An insulating cylinder 218 made of, for example, the heat resistant material such as quartz or SiC is installed below the boat 217.

A temperature sensor 263 serving as a temperature detector is installed inside inner tube 204. Based on temperature information detected by the temperature sensor 263, an amount of electric power supplied to the heater 207 is regulated such that a desired temperature distribution is achieved inside the process chamber 201.

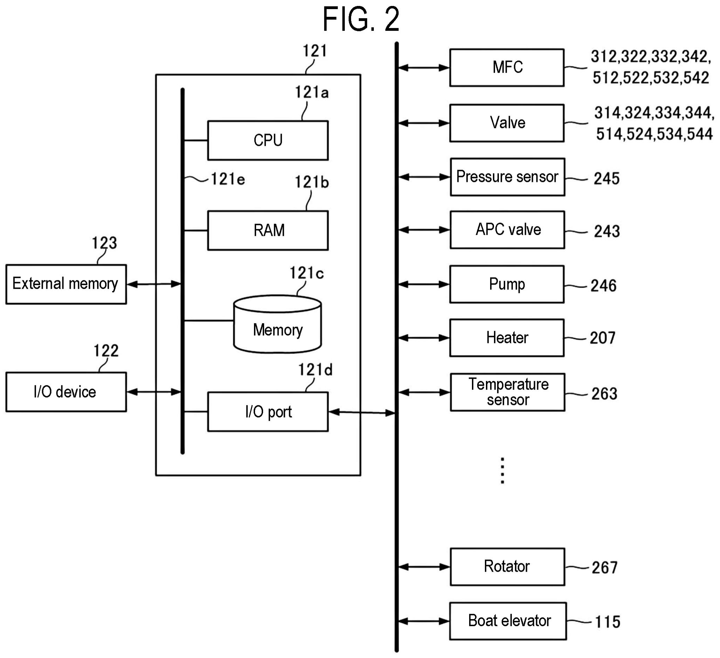

As illustrated in FIG. 2, a controller 121, which is a control part (control means or unit), is constituted as a computer including a central processing unit (CPU) 121a, a random access memory (RAM) 121b, a memory 121c, and an input/output (I/O) port 121d. The RAM 121b, the memory 121c, and the I/O port 121d are configured to be capable of exchanging data with the CPU 121a via an internal bus 121e. An I/O device 122 constituted as, for example, a touch panel or the like, is connected to the controller 121.

The memory 121c is constituted by, for example, a flash memory, a hard disk drive (HDD), or the like. A control program that controls an operation of a substrate processing apparatus, a process recipe in which procedures or conditions of a method of manufacturing a semiconductor device as described later are written, or the like is readably stored in the memory 121c. The process recipe functions as a program combined to cause the controller 121 to execute the respective processes (steps) in the method of manufacturing the semiconductor device described later, so as to obtain a predetermined result. Hereinafter, the process recipe and the control program will be generally and simply referred to as a "program." When the term "program" is used herein, it may indicate a case of including the process recipe, a case of including the control program, or a case of including both the process recipe and the control program. The RAM 121b is configured as a memory area (work area) in which program, data or the like read by the CPU 121a is temporarily stored.

The I/O port 121d is connected to the MFCs 312, 322, 332, 342, 512, 522, 532, and 542, the valves 314, 324, 334, 344, 514, 524, 534, and 544, the pressure sensor 245, the APC valve 243, the pump 246, the heater 207, the temperature sensor 263, the rotator 267, the BE 115, and the like.

The CPU 121a is configured to read the control program from the memory 121c and execute the read control program. The CPU 121a is also configured to read the recipe from the memory 121c according to input of an operation command from the I/O device 122. The CPU 121a is configured to be capable of controlling flow rate regulating operation of various kinds of gases by the MFCs 312, 322, 332, 342, 512, 522, 532, and 542, opening/closing operations of the valves 314, 324, 334, 344, 514, 524, 534, and 544, an opening/closing operation of the APC valve 243, a pressure regulating operation performed by the APC valve 243 based on the pressure sensor 245, a temperature regulating operation of the heater 207 based on the temperature sensor 263, actuating and stopping operations of the pump 246, operations of rotating the boat 217 and adjusting a rotation speed of the boat 217 by the rotator 267, an operation of moving the boat 217 up or down by the BE 115, an operation of accommodating the wafers 200 in the boat 217, and the like, according to contents of the read recipe.

The controller 121 can be constituted by installing, on the computer, the aforementioned program stored in an external memory 123 (e.g., a magnetic disk such as a HDD, an optical disc such as a CD or DVD, or a semiconductor memory such as a flash memory). The memory 121c or the external memory 123 is constituted as a computer-readable recording medium. Hereinafter, the memory 121c and the external memory 123 may be generally and referred to as a "recording medium." When the term "recording medium" is used herein, it may indicate a case of including the memory 121c, a case of including the external memory 123, or a case of including both the memory 121c and the external memory 123. The program (program product) may be provided to the computer by using a communication means or unit such as the Internet or a dedicated line, instead of using the external memory 123.

### (2) Substrate Processing Process (Processing Method)

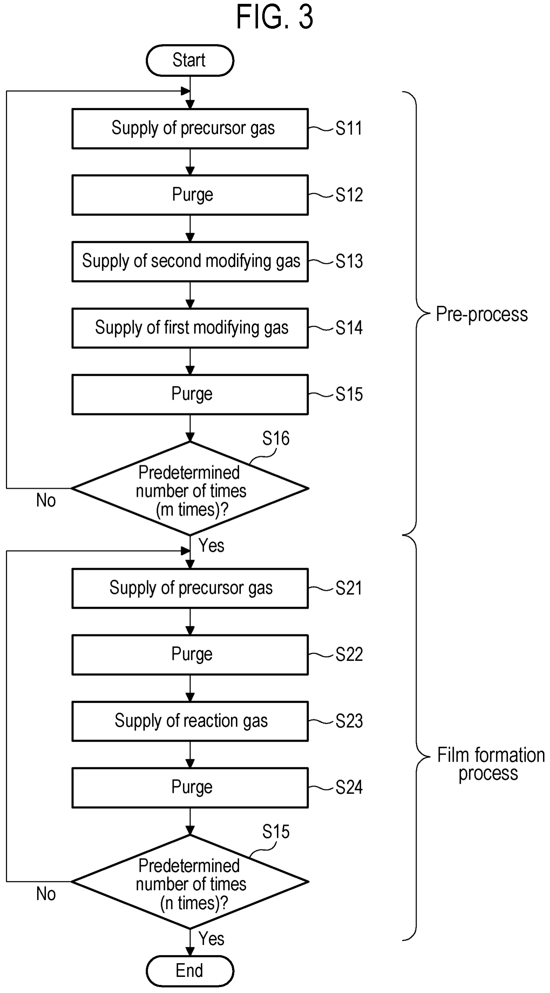

As a process of manufacturing a semiconductor device, an example of a process of forming a film containing a first predetermined element on the wafer 200, which is a material including a predetermined surface, will be described with reference to FIGS. 3 and 4A to 4H. The process is performed by using the process furnace 202 of the aforementioned substrate processing apparatus 10. In the following description, operations of the respective components constituting the substrate processing apparatus 10 is controlled by the controller 121.

Here, the predetermined surface refers to a surface of a silicon oxide film (SiO film), which is a second predetermined material containing silicon (Si) as a second predetermined element constituting the wafer 200. That is, a film containing a first predetermined element is formed on the wafer 200 with the SiO film being formed on the surface thereof. Specifically, the film containing the first predetermined element is formed on the wafer 200 including the predetermined surface and containing, on its surface, Si-OH terminations and Si-O-Si bonds.

When a precursor gas containing the first predetermined element and a halogen element is supplied to the wafer 200 containing the Si-OH terminations and the Si-O-Si bonds on its surface to form a thin first predetermined element-containing film, the first predetermined element may grow in an island shape in an initial stage of film formation, resulting in a region that is not covered. It was confirmed that this occurs because the halogen element is adsorbed on the surface of the wafer 200, which makes it difficult for the first predetermined element to be adsorbed on and cover the surface. According to verification of the present discloser, it was confirmed that coverage of the first predetermined element-containing film is improved by performing a pre-process, which will be described later, prior to the film formation process.

A process of processing a substrate (a process of manufacturing a device) according to the embodiments of the present disclosure includes:
a first process of modifying a predetermined surface of a wafer 200, the first process including:
   (a1) supplying a precursor gas containing a first predetermined element and a halogen element to the wafer 200 including the predetermined surface;
   (a2) after (a1), supplying a first modifying gas containing oxygen to the wafer 200; and
   (a3) after (a1), supplying a second modifying gas, which is different from the first modifying gas, to the wafer 200; and
a second process of forming a film containing the first predetermined element on the modified predetermined surface after the first process, wherein the second process is performed a predetermined number of times, the second process including:
   (b1) supplying the precursor gas to the wafer 200; and
   (b2) supplying a reaction gas to the wafer 200.

In the present disclosure, the above-described processing sequence may, for convenience, be represented as described below. The same notation is also used in the following description of modifications.
(Precursor gas → P → second modifying gas → first modifying gas → P) × m → (precursor gas → P → reaction gas → P) × n ⇒ first predetermined element-containing film.

In the present disclosure, the symbol "P" indicates that a purge process is performed to purge an inside of the process chamber 201.

In the present disclosure, the term "wafer" may be used to refer to a "wafer itself" or a "stacked body of a wafer and a predetermined layer or film formed on a surface of the wafer." In the present disclosure, the phrase "a surface of a wafer" may be used to refer to "a surface of a wafer itself" or "a surface of a predetermined layer or film formed on the wafer". In the present disclosure, the term "substrate" is synonymous with the term "wafer."

### (Wafer Loading)

First, a plurality of wafers 200 are charged into the boat 217. In a case where the plurality of wafers 200 are charged into the boat 217, as illustrated in FIG. 1, the boat 217 supporting the plurality of wafers 200 is lifted up by the BE 115 and is loaded into the process chamber 201 of the process container and accommodated in the process container.

### (Pressure Regulation and Temperature Regulation)

The inside of the process chamber 201, i.e., a space in which the wafers 200 are present, is exhausted by the pump 246 so as to reach a desired pressure. In this case, an internal pressure of the process chamber 201 is measured by the pressure sensor 245, and the APC valve 243 is feedback-controlled based on information on the measured pressure (pressure regulation). The pump 246 is maintained in a regular operation state at least until processing of the wafers 200 is completed. Further, the inside of the process chamber 201 is heated by the heater 207 so as to reach a desired temperature. In this case, an amount of electric power supplied to the heater 207 is feedback-controlled based on information on the temperature detected by the temperature sensor 263 such that a desired temperature distribution is achieved inside the process chamber 201 (temperature regulation). The heating of the inside of the process chamber 201 by the heater 207 is continuously performed at least until processing of the wafers 200 is completed.

### (Pre-process)

First, as a pre-process (also referred to as a first process), the following steps S11 to S16 are performed.

### [Supply of Precursor Gas, Step S11]

The valve 314 is opened to allow a precursor gas to flow through the gas supply pipe 310. The precursor gas, a flow rate of which is regulated by the MFC 312, is supplied into the process chamber 201 from the gas supply hole 410a of the nozzle 410 and is exhausted via the exhaust pipe 231. In this case, the valves 514 to 544 may be opened to supply an inert gas into the process chamber 201 via the nozzles 410 to 440, respectively.

Processing conditions when the precursor gas is supplied in this step are exemplified as follows:
Processing temperature: 300 to 600 degrees C, specifically, 400 to 560 degrees C, more specifically, 450 to 530 degrees C
Processing pressure: 1 to 3,990 Pa
Supply flow rate of precursor gas: 0.1 to 1 slm
Supply time of precursor gas: 0.01 to 60 seconds
Supply flow rate of inert gas (for each nozzle): 0.1 to 30 slm

The processing temperature may be set to substantially the same temperature in any of the following steps. The processing temperature in the present disclosure means a temperature of the wafer 200 or an internal temperature of the process chamber 201, and the processing pressure means an internal pressure of the process chamber 201. The processing time means a time during which a process is continued. The same also applies to the following description. In the present disclosure, expression of a numerical range such as "300 to 600 degrees C" means that a lower limit and an upper limit are included in that range. Therefore, for example, "300 to 600 degrees C" means "300 degrees C or higher and 600 degrees C or lower." The same applies to other numerical ranges. When the supply flow rate includes 0 slm, 0 slm means that a material (gas) is not supplied. The same applies to the following description.

As the precursor gas, a gas containing the first predetermined element and the halogen element may be used.

The first predetermined element may be, in addition to silicon (Si), metal elements such as tungsten (W), titanium (Ti), zirconium (Zr), hafnium (Hf), molybdenum (Mo), ruthenium (Ru), aluminum (Al), gallium (Ga), germanium (Ge), tantalum (Ta), cobalt (Co), yttrium (Y), and the like. One or more of these elements may be used as the first predetermined element.

As the halogen element, for example, chlorine (Cl), fluorine (F), iodine (I), bromine (Br), and the like may be used. As the halogen element, one or more of these elements may be used.

As the gas containing the first predetermined element and the halogen element, for example, a gas may be used such as titanium tetrachloride (TiCl₄), titanium tetrafluoride (TiF₄), hexachlorotungsten (WCl₆), hexafluorotungsten (WF₆), molybdenum pentachloride (MoCl₅), molybdenum pentafluoride (MoF₅), molybdenum dioxide dichloride (MoO₂Cl₂), molybdenum oxide tetrachloride (MoOCl₄), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃Cl₃), pentachlorodisilane (Si₂HCl₅), tetrachlorosilane (SiCl₄), hexachlorodisilane (Si₂Cl₆), tetrafluorosilane (SiF₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), and the like. As the gas containing the first predetermined element and the halogen element, one or more of these elements may be used.

As the inert gas, for example, in addition to nitrogen (N₂) gas, a rare gas such as argon (Ar) gas, helium (He) gas, neon (Ne) gas, xenon (Xe) gas, and the like may be used. One or more of these gases may be used as the inert gas. The same applies to the inert gas in the following description.

In this case, the precursor gas is supplied to the wafer 200 containing the Si-OH terminations and the Si-O-Si bonds on the surface thereof. Accordingly, at least a part of the Si-OH terminations and the Si-O-Si bonds on the wafer 200 are substituted with the precursor gas or a part of molecules of the precursor gas, such that a first atomic group containing Si and the first predetermined element and a second atomic group containing Si and the halogen element are formed on at least a part of the surface of the wafer 200.

Specifically, in a case where, for example, MCl₄ gas is used as the precursor gas, by supplying the MCl₄ gas, M bonds to O in at least a part of the Si-OH terminations and the Si-O-Si bonds on the surface of the wafer 200, as shown in FIGS. 4A and 4B. As a result, a bond of Si-O-MClₓ (where x is an integer of 4 or less), which is the first atomic group containing Si and M, is formed. Further, Cl desorbed from MCl₄ bonds to adjacent Si, thereby forming a Si-Cl bond, which is the second atomic group containing Si and Cl. Here, M is the above-described first predetermined element.

### [Purge, Step S12]

After the first atomic group containing Si and the first predetermined element and the second atomic group containing Si and the halogen element are formed on the surface of the wafer 200, the valve 314 is closed to stop the supply of the precursor gas into the process chamber 201. In this case, the APC valve 243 of the exhaust pipe 231 is kept open, and the inside of the process chamber 201 is vacuum-exhausted by the pump 246. As a result, a residual gas is removed from the wafer 200, and a gas or a byproduct remaining in the process chamber 201 is excluded from the inside of the process chamber 201. In this case, the valves 514, 524, 534, and 544 are kept open to maintain the supply of the inert gas into the gas supply pipes 510, 520, 530, and 540. The inert gas functions as a purge gas, thereby purging the inside of the process chamber 201 (purge).

### [Supply of Second Modifying Gas, Step S13]

The valve 344 is opened to allow the second modifying gas to flow through the gas supply pipe 340. The second modifying gas, the flow rate of which is regulated by the MFC 342, is supplied into the process chamber 201 from the gas supply hole 440a of the nozzle 440 and is exhausted via the exhaust pipe 231. In this case, the valves 514 to 544 may be opened to supply the inert gas into the process chamber 201 via the nozzles 410 to 440, respectively.

Processing conditions when the second modifying gas is supplied in this step are exemplified as follows.
Supply flow rate of second modifying gas: 0.1 to 30 slm
Supply time of second modifying gas: 0.01 to 60 seconds

As the second modifying gas, a gas containing hydrogen (H) may be used.

As the gas containing H, a hydrogen nitride-based gas containing nitrogen (N), and the like may also be used.

As the hydrogen nitride-based gas containing H and N, for example, ammonia (NH₃) gas, diazene (N₂H₂) gas, hydrazine (N₂H₄) gas, triazane (N₃H₅) gas, a mixed gas of N₂ gas and hydrogen (H₂) gas, and the like may be used. As the hydrogen nitride-based gas, one or more of these gases may be used. As the hydrogen nitride-based gas, one or more of these gases may be radicals or plasma, but non-plasma is desirable.

In this case, the second modifying gas is supplied to the surface of the wafer 200 after the first atomic group containing Si and the first predetermined element and the second atomic group containing Si and the halogen element are formed. Accordingly, at least a part of the halogen element contained in the first atomic group on the wafer 200 is substituted with the second modifying gas or a part of molecules of the second modifying gas.

Specifically, when, for example, the hydrogen nitride-based gas is used as the second modifying gas, by the supply of the hydrogen nitride-based gas, Cl contained in a Si-O-MClₓ bond of the first atomic group, for example, on the surface of the wafer 200 is substituted with a NH group to form a Si-O-MNH_{y} (where y is a natural number) bond, as shown in FIGS. 4C and 4D. Then, Cl desorbed from the surface of the wafer 200 becomes a reaction byproduct such as Cl₂ or HCl, and the byproduct is removed from the process chamber 201.

### [Supply of First Modifying Gas Supply, Step S14]

The valve 334 is opened to allow the first modifying gas to flow through the gas supply pipe 330. The first modifying gas, the flow rate of which is regulated by the MFC 332, is supplied into the process chamber 201 from the gas supply hole 430a of the nozzle 430 and is exhausted via the exhaust pipe 231. In this case, the valves 514 to 544 may be opened to supply the inert gas into the process chamber 201 via the nozzles 410 to 440, respectively.

Processing conditions when the first modifying gas is supplied in this step are exemplified below.
Supply flow rate of first modifying gas: 0.1 to 10 slm
Supply time of first modifying gas: 0.01 to 60 seconds
In this case, the first modifying gas is continuously supplied.

As the first modifying gas, an oxygen (O)-containing gas containing O may be used.

As the O-containing gas, for example, oxygen (O₂) gas, ozone (O₃) gas, nitrous oxide (N₂O) gas, nitrogen monoxide (NO) gas, nitrogen dioxide (NO₂) gas, carbon monoxide (CO) gas, carbon dioxide (CO₂) gas, a gas containing O and H, and the like may be used. As the O-containing gas, one or more of these gases may be used.

As the gas containing O and H, for example, water (H₂O) gas, hydrogen peroxide (H₂O₂) gas, a mixed gas of H₂ gas and O₂ gas, a mixed gas of H₂ gas and O₃ gas, and the like may be used. As the gas containing O and H, one or more of these gases may be used. As the gas containing O and H, one or more of these gases may be radicals or plasma, but non-plasma is desirable to generate a small amount of H₂O. That is, it is desirable to perform the process without bringing plasma into contact with the wafer 200. In addition, as the gas containing O and H, an O-containing gas and a H-containing gas may be supplied simultaneously. To actively generate H₂O, simultaneous supply is desirable.

In this case, the first modifying gas is supplied to the surface of the wafer 200 in which at least a part of the halogen element contained in the first atomic group is substituted with the second modifying gas or a part of molecules of the second modifying gas. In this case, the first modifying gas reacts with the second modifying gas in the process chamber 201 to generate a small amount of water (H₂O). Then, by this small amount of H₂O, at least a part of the halogen element contained in the second atomic group on the wafer 200 is substituted with an OH group (also referred to as an OH termination), which is likely to bond to the first predetermined element.

Specifically, in a case where, for example, the O-containing gas is used as the first modifying gas, a small amount of H₂O is generated by the supply of the O-containing gas, as shown in FIGS. 4E and 4F. Then, by this small amount of H₂O, Cl of the second atomic group containing Si and Cl is substituted with an OH group to which M bonds by the subsequent supply of the precursor gas, thereby forming a Si-OH termination. Then, Cl desorbed from the surface of the wafer 200 becomes a reaction byproduct such as Cl₂ or HCl and the reaction byproduct is removed from the inside of the process chamber 201.

In addition, the above-described step S13 and step S14 may be performed in this order. This may prevent generation of excessive H₂O, thereby generating a small amount of H₂O. In a case where excessive H₂O is generated, the formed film is oxidized, which may increase resistivity. By generating a small amount of H₂O as in this embodiment, it is possible to improve coverage of the formed film while suppressing oxidation of the formed film. Furthermore, although particles may be generated in a case where H₂O is supplied alone instead of using the first modifying gas and the second modifying gas, the generation of the particles may be suppressed by using the above-described first modifying gas and second modifying gas. Additionally, step S13 and step S14 may be executed such that timings thereof partially overlap. That is, a timing may be provided at which step S13 and step S14 are performed simultaneously. By providing the timing at which step S13 and step S14 are performed simultaneously, H₂O may be actively generated. By actively generating H₂O, oxidation of the formed film may be promoted. This method may be used, for example, when forming an oxygen-containing film on the wafer 200.

### [Purge, Step S15]

After the surface of the wafer 200 is modified with the OH group, the valve 334 is closed to stop the supply of the first modifying gas into the process chamber 201. In this case, the APC valve 243 of the exhaust pipe 231 is kept open, and the inside of the process chamber 201 is vacuum-exhausted by the pump 246. As a result, a residual gas is removed from the wafer 200, and a gas or a reaction byproduct remaining in the process chamber 201 is excluded from the inside of the process chamber 201. In this case, the valves 514, 524, 534, and 544 are kept open to maintain the supply of the inert gas into the gas supply pipes 510, 520, 530, and 540. The inert gas functions as the purge gas, thereby purging the inside of the process chamber 201

(purge).

### [Performing Predetermined Number of Times, Step S16]

The above-described steps S11 to S15 are performed in this order a predetermined number of times (m times, where m is an integer of 1 or 2 or more). Accordingly, the predetermined surface of the wafer 200 is modified to form a layer containing the first predetermined element, which contains the OH group, on the surface of the wafer 200.

### (Film Formation Process)

Next, the following step S21 to step S25 as a film formation process (also referred to as a second process) are performed.

### [Supply of Precursor Gas, Step S21]

Similar to the above-described step S11, the valve 314 is opened to allow the precursor gas to flow through the gas supply pipe 310. The precursor gas, a flow rate of which is regulated by the MFC 312, is supplied into the process chamber 201 from the gas supply hole 410a of the nozzle 410 and is exhausted via the exhaust pipe 231. In this case, the valves 514 to 544 may be opened to supply the inert gas into the process chamber 201 via the nozzles 410 to 440, respectively.

Processing conditions when the precursor gas is supplied in this step are exemplified below.
Supply flow rate of precursor gas: 0.1 to 1 slm
Supply time of precursor gas: 0.01 to 60 seconds

As the precursor gas, the gas used in step S11 described above may be similarly used.

In this case, the precursor gas is supplied to the wafer 200 on which a layer containing the first predetermined element, which contains the OH group, on the surface thereof is formed. As a result, the OH group on the wafer 200 reacts with the precursor gas to form a first layer containing the first predetermined element.

Specifically, in a case where, for example, MCl₄ gas is used as the precursor gas, by supplying the MCl₄ gas, M bonds to O on the surface of the wafer 200, such that a Si-O-MClₓ bond and a Si-O-MNHCl_{z} bond (where z is a natural number) are formed, thereby forming the first layer containing M, as shown in FIGS. 4G and 4H.

### [Purge, Step S22]

After the first layer containing the first predetermined element is formed on the surface of the wafer 200, the valve 314 is closed to stop the supply of the precursor gas into the process chamber 201. In this case, the APC valve 243 of the exhaust pipe 231 is kept open, and the inside of the process chamber 201 is vacuum-exhausted by the pump 246. As a result, a residual gas is removed from the wafer 200, and a gas or a reaction byproduct remaining in the process chamber 201 is excluded from the inside of the process chamber 201. In this case, the valves 514, 524, 534, and 544 are kept open to maintain the supply of the inert gas into the gas supply pipes 510, 520, 530, and 540. The inert gas functions as the purge gas, thereby purging the inside of the process chamber 201 (purge).

### (Supply of Reaction Gas, Step S23)

Subsequently, the valve 324 is opened to allow the reaction gas to flow through the gas supply pipe 320. The reaction gas, the flow rate of which is regulated by the MFC 322, is supplied into the process chamber 201 from the gas supply hole 420a of the nozzle 420 and is exhausted via the exhaust pipe 231. In this case, the valves 514 to 544 may be opened to supply the inert gas into the process chamber 201 via the nozzles 410 to 440, respectively.

Processing conditions when the reaction gas is supplied in this step are exemplified as follows.
Supply flow rate of reaction gas: 0.1 to 30 slm
Supply time of reaction gas: 0.01 to 30 seconds

As the reaction gas, for example, a nitriding agent or an oxidizing agent may be used.

As the nitriding agent (nitriding gas), for example, a N- and H-containing gas may be used. As the N- and H-containing gas, for example, a hydrogen nitride-based gas such as a NH₃ gas, a N₂H₂ gas, a N₂H₄ gas, N₃H₅ gas, and the like may be used. As the nitriding agent, one or more of these gases may be used. In this step, when the nitriding agent is used as the reaction gas, the first layer is nitrided and modified into a nitride layer.

As the oxidizing agent (oxidizing gas), for example, an O- and H-containing gas may be used. As the O- and H-containing gas, for example, a H₂O gas, a H₂O₂ gas, a mixed gas of H₂ gas and O₂ gas, a mixed gas of H₂ gas and O₃ gas, and the like may be used. In addition, as the oxidizing agent, for example, an O-containing gas may be used in addition to the O- and H-containing gas. As the O-containing gas, for example, an O₂ gas, an O₃ gas, a N₂O gas, a NO gas, a NO₂ gas, a CO gas, a CO₂ gas, and the like may be used. Further, the O-and H-containing gas is a type of O-containing gas. As the oxidizing agent, one or more of these gases may be used. In a case where the oxidizing agent is used in this step as the reaction gas, the first layer is oxidized and modified into an oxide layer.

The term "agent" used in the present disclosure includes at least one selected from the group of a gaseous substance and a liquid substance. The liquid substance includes a misty substance. That is, the nitriding agent and the oxidizing agent may include a gaseous substance, a liquid substance such as a misty state substance or the like, or both thereof.

In this case, the reaction gas is supplied to the wafer 200 on which the first layer containing the first predetermined element is formed. As a result, at least a part of the first layer on the wafer 200 undergoes a substitution reaction with a part of the reaction gas, thereby forming a second layer. A reaction byproduct generated by this substitution reaction is desorbed from the first layer and discharged from the inside of the process chamber 201.

Specifically, when, for example, the nitriding agent is used as the reaction gas, by the supply of the nitriding agent, M contained in the first layer on the surface of the wafer 200 and N contained in the nitriding agent bond to each other, thereby forming the second layer containing M and N on the wafer 200. Cl desorbed from the surface of the wafer 200 becomes a reaction byproduct such as Cl₂ or HCl and is removed from the inside of the process chamber 201.

### [Purge, Step S24]

After the second layer is formed on the surface of the wafer 200, the valve 324 is closed to stop the supply of the reaction gas into the process chamber 201. In this case, the APC valve 243 of the exhaust pipe 231 is kept open, and the inside of the process chamber 201 is vacuum-exhausted by the pump 246. As a result, a residual gas is removed from the wafer 200, and a gas remaining or a reaction byproduct in the process chamber 201 is excluded from the inside of the process chamber 201. In this case, the valves 514, 524, 534, and 544 are kept open to maintain the supply of the inert gas into the gas supply pipes 510, 520, 530, and 540. The inert gas functions as the purge gas, thereby purging the inside of the process chamber 201 (purge).

### [Performing Predetermined Number of Times, Step S25]

By performing the above-described steps S21 to S24 in this order a predetermined number of times (n times, where n is an integer of 1 or 2 or more), a first predetermined element-containing film with a predetermined thickness is formed on the surface of the wafer 200 modified in the pre-process. In this way, a film formation process is performed after the predetermined surface of the wafer 200 is modified so as to generate an OH group while removing the halogen element in the pre-process. Thereby, the coverage of the first predetermined element-containing film formed on the surface of the wafer 200 may be improved.

### (Purge and Returning to Atmospheric Pressure)

The inert gas is supplied into the process chamber 201 from each of the gas supply pipes 510 to 540 and exhausted via the exhaust pipe 231. The inert gas functions as the purge gas, and thus, the inside of the process chamber 201 is purged with the inert gas and a gas or a reaction byproduct remaining in the process chamber 201 is removed from the inside of the process chamber 201. Thereafter, an internal atmosphere of the process chamber 201 is substituted with the inert gas, and the pressure inside the process chamber 201 is returned to atmospheric pressure.

### (Wafer Unloading)

Next, the SC 219 is moved down by the BE 115 to open a lower end of the outer tube 203. Then, the processed wafers 200, while being supported by the boat 217, are unloaded from the lower end of the outer tube 203 to the outside of the outer tube 203. Thereafter, the processed wafers 200 are discharged from the boat 217.

### (3) Modifications

The substrate processing process in the embodiments is not limited to the embodiments shown in FIG. 3 and may be modified as in modifications described below.

### (First and Second Modifications)

The first and second modifications differ from the above-described substrate processing process in terms of the pre-process.

### (First Modification)

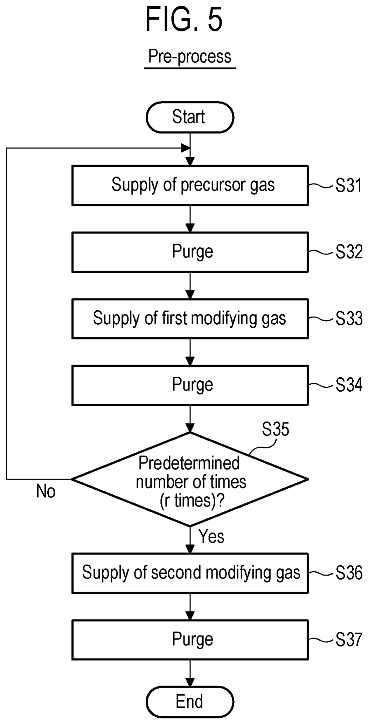

In this modification, as shown in FIG. 5, as the pre-process, supply of precursor gas (step S31) similar to step S11 described above, purge (step S32) similar to step S12 described above, supply of first modifying gas (step S33) similar to step S14 described above, and purge (step S34) similar to step S15 described above are performed a predetermined number of times (r times, where r is an integer of 1 or 2 or more, specifically, a plurality of times) (step S35). Thereafter, supply of second modifying gas (step S36) similar to step S13 described above and purge (step S37) are performed. The substrate processing process of this modification may also be expressed as follows.
(Precursor gas → P → first modifying gas → P) × r → second modifying gas → P → film formation process ⇒ first predetermined element-containing film.

In this modification as well, the same effects as those in the above-described embodiments are obtained. Further, in this modification, a film containing the first predetermined element, O, and N may be formed on the surface of the wafer 200.

### (Second Modification)

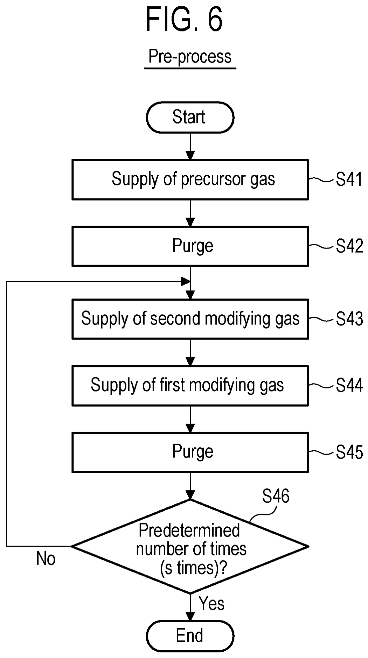

In this modification, as the pre-process, as shown in FIG. 6, after performing supply of precursor gas (step S41) similar to step S11 described above and purge (step S42) similar to step S12 described above, supply of second modifying gas (step S43) similar to step S13 described above, supply of first modifying gas (step S44) similar to step S14 described above, and purge (step S45) similar to step S15 described above are performed a predetermined number of times (s times, where s is an integer of 1 or 2 or more) (step S46). The substrate processing process of this modification may also be expressed as follows.

Precursor gas → P → (second modifying gas → first modifying gas → P) × s → film formation process ⇒ first predetermined element-containing film.

In this modification as well, the same effects as those in the above-described embodiments are obtained. Further, in this modification, the amount of H₂O generated may be increased as compared with the above-described embodiments and modifications.

### (Third and Fourth Modifications)

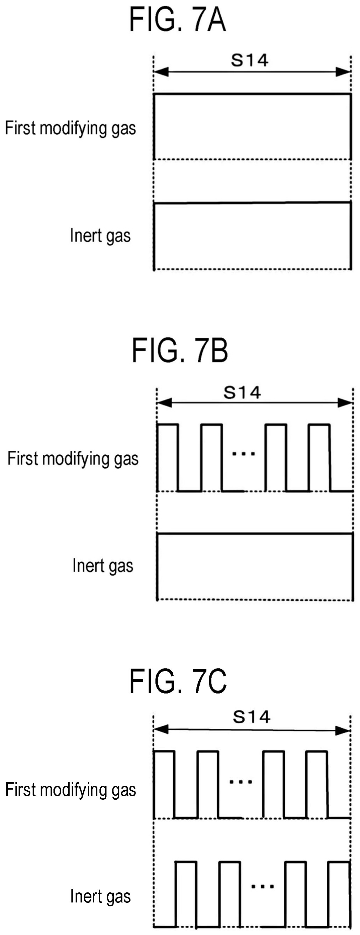

The third and fourth modifications differ in supply of first modifying gas in step S14 of the pre-process from the above-described substrate processing process. That is, in step S14 described above, as shown in FIG. 7A, the case in which the first modifying gas is continuously supplied for a predetermined time is described, but in the third and fourth modifications, the first modifying gas is pulse-supplied in step S14.

### (Third Modification)

In this modification, as shown in FIG. 7B, in step S14 described above, the pulse supply of the first modifying gas is performed a predetermined number of times (t times, where t is an integer of 2 or more, i.e., a plurality of times), and the inert gas is continuously supplied between the pulse supplies of the first modifying gas. In this modification as well, the same effects as those of the above-described embodiments are obtained. In this modification, it is possible to reduce an amount of oxygen supplied to a region that is not intended to be oxidized, i.e., where adsorption of O₂ is not intended.

### (Fourth Modification)

In this modification, as shown in FIG. 7C, in step S14 described above, the pulse supply of the first modifying gas is performed a predetermined number of times (t times, where t is an integer of 2 or more, i.e., a plurality of times), and the inert gas is pulse-supplied between the pulse supplies of the first modifying gas. In this modification as well, the same effects as those of the above-described embodiments and modifications are obtained.

In addition, the pulse supply of the first modifying gas may be performed a predetermined number of times (t times, where t is an integer of 2 or more; i.e., a plurality of times), and exhaust may be performed between the pulse supplies of the first modifying gas. Furthermore, the pulse supply of the first modifying gas may be performed a predetermined number of times (t times, where t is an integer of 2 or more, i.e., a plurality of times), and the supply and exhaust of the inert gas may be performed between the pulse supplies of the first modifying gas. In this modification as well, the same effects as those in the above-described embodiments and modifications are obtained. In this modification, even in a case where excessive H₂O is generated, an amount of H₂O within the process chamber 201 may be reduced by the exhaust process.

### (Fifth to Seventh Modifications)

The fifth to seventh modifications differ in the supply of precursor gas in step S21 of the film formation process from the above-described substrate processing process. In these modifications, as described below, in the supply of precursor gas of step S21 of the film formation process described above, a reducing gas is supplied at least partially simultaneously (in parallel) with the precursor gas. The film formation processes of these modifications may also be expressed as follows.
Pre-process → (precursor gas → precursor gas + reducing gas → reducing gas → P → reaction gas → P) × n ⇒ first predetermined element-containing film
Pre-process → (precursor gas → precursor gas + reducing gas → precursor gas → P → reaction gas → P) × n ⇒ first predetermined element-containing film
Pre-process → (precursor gas → precursor gas + reducing gas → P → reaction gas → P) × n ⇒ first predetermined element-containing film

That is, timings are provided at which the precursor gas and the reducing gas are supplied simultaneously. In these modifications, a reducing gas supply system configured to supply the reducing gas to the above-described substrate processing apparatus 10 is additionally installed.

### (Fifth Modification)

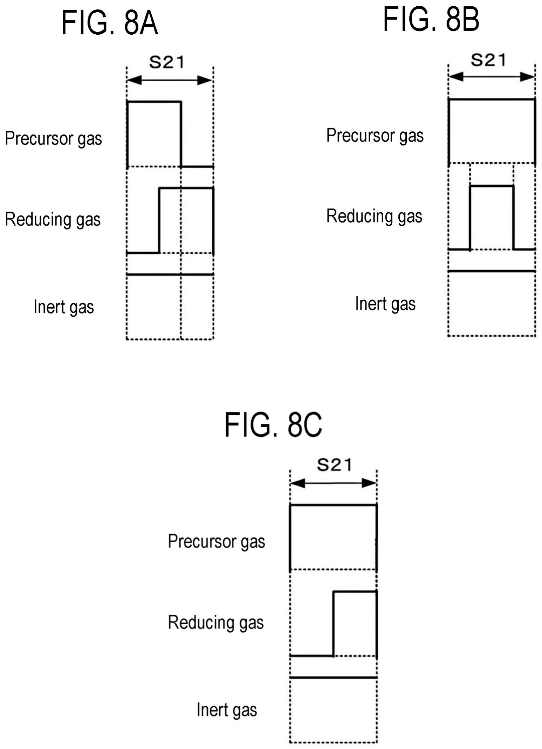

In this modification, in step S21 of the film formation process, as shown in FIG. 8A, the supply of the reducing gas is started after a predetermined time elapses since the valve 314 is opened to start the supply of the precursor gas. Then, after a predetermined time elapses since the supply of the reducing gas is started, the valve 314 is closed to stop the supply of the precursor gas, and after a predetermined time elapses thereafter, the supply of the reducing gas is stopped. In this modification as well, the same effects as those of the above-described embodiments and modifications are obtained. Further, in this modification, a film quality of the first predetermined element-containing film may be improved by suppressing inhibition of adsorption of the precursor gas while reducing the amount of reaction byproducts generated by the supply of the precursor gas.

### (Sixth Modification)

In this modification, in step S21 of the film formation process, as shown in FIG. 8B, the supply of the reducing gas is started after a predetermined time elapses since the valve 314 is opened to start supply of the precursor gas. Then, after a predetermined time elapses since supply of the reducing gas is started, the supply of the reducing gas is stopped and, after a predetermined time elapses thereafter, the valve 314 is closed to stop the supply of the precursor gas. In this modification as well, the same effects as those of the above-described embodiments and modifications are obtained. Further, in this modification, the film quality of the first predetermined element-containing film may be improved by suppressing inhibition of adsorption of the precursor gas on the wafer 200 while reducing the amount of reaction byproducts generated by the supply of the precursor gas.

### (Seventh Modification)

In this modification, in step S21 of the film formation process, as shown in FIG. 8C, the supply of the reducing gas is started after a predetermined time elapses since the valve 314 is opened to start the supply of the precursor gas. Then, after a predetermined time elapses since the supply of the reducing gas is started, the supply of the precursor gas and the supply of the reducing gas are simultaneously stopped. In this modification as well, the same effects as those of the above-described embodiments and modifications are obtained. Further, in this modification, the film quality of the first predetermined element-containing film may be improved by suppressing the inhibition of adsorption of the precursor gas on the wafer 200 while reducing the amount of reaction byproducts generated by the supply of the precursor gas.

Further, in step S21 of the film formation process, the supply of the precursor gas and the supply of the reducing gas may be simultaneously started and simultaneously stopped. In this modification as well, the same effects as those of the above-described embodiments and modifications are obtained.

As the reducing gas, for example, a gas containing at least one selected from the group of Group 13 elements and Group 14 elements of the periodic table and a H-containing gas may be used. As such a gas, for example, a silane-based gas such as SiH₄, Si₂H₆, or Si₃H₈, or a borane-based gas such as BH₃ or B₂H₆ may be used. As the reducing gas, such a hydride may be used.

By supplying, for example, SiH₄ gas, as the reducing gas, hydrogen chloride (HCl) and the like, which are reaction byproducts and inhibit film formation, are removed. Accordingly, adsorption sites on the wafer 200 on which the precursor gas may be adsorbed are empty, and adsorption sites on which the precursor gas or a part of molecules of the precursor gas may be adsorbed may be formed on the surface of the wafer 200. Here, the adsorption sites on which the precursor gas or a part of molecules of the precursor gas may be adsorbed mean locations (areas) on the wafer 200 on which adsorption-inhibiting substances such as HCl are not adsorbed.

### (4) Other Embodiments

In the above-described embodiments, the case in which supply of the second modifying gas in step S13 and supply of the first modifying gas in step S14 of the above-described pre-process are performed in this order is described as an example. However, the present disclosure is not limited thereto. The present disclosure may also be suitably applied to the case in which step S13 and step S14 of the above-described pre-process are performed at least partially simultaneously.

Further, in the above-described embodiments and modifications, the case in which the gas containing H is used as the second modifying gas is described as an example. However, the present disclosure is not limited thereto. The inert gas may be used as the second modifying gas. A surface state of the wafer 200 may be modified by supplying the inert gas before or after supplying the first modifying gas. Further, when the inert gas is supplied before supplying the first modifying gas, the amount of molecules of the precursor gas present in a processing space, i.e., on the surface of the wafer 200 may be reduced. In addition, when the inert gas is supplied after supplying the first modifying gas, the amount of the first modifying gas present in the processing space, i.e., on the surface of the wafer 200 may be regulated.

Further, in the above-described embodiments and modifications, the case in which the film formation process is performed after the pre-process is performed on the wafer 200 is described as an example. However, the present disclosure is not limited thereto. The present disclosure may also be suitably applied to a case in which other processes such as modification, etching, and removal of native oxide film are performed after performing the pre-process. That is, the pre-process of the above-described embodiments and modifications may also be suitably applied to a technique that generates H₂O in modification, etching, removal of native oxide film, and the like.

Further, in the above-described embodiments and modifications, the case in which the film formation process is performed after the pre-process is performed on the wafer 200 as a material including a predetermined surface is described as an example. However, the present disclosure is not limited thereto. The present disclosure may also be suitably applied to a case in which the above-described pre-process is performed on the inside of a process container, members in the process container, and the like, as a material including the predetermined surface. The members in the process container are, for example, the nozzles 410, 420, 430, and 440, the boat 217, and the like.

Furthermore, in the above-described embodiments and modifications, an example in which the above-described processing sequence is performed in the same process chamber of the same processing apparatus (in-situ) is described. The present disclosure is not limited to the above-described embodiments and modifications, and any step of the above-described processing sequence and other steps may be performed, for example, in different process chambers of different processing apparatuses (ex-situ) or may be performed in different process chambers of the same processing apparatus.

In the above-described embodiments and modifications, an example in which a film is formed by using a batch-type substrate processing apparatus configured to process a plurality of wafers 200 at a time is described. The present disclosure is not limited to the above-described embodiments and may be suitably applied to, for example, the case in which a film is formed by using a single-wafer-type substrate processing apparatus configured to process one or several wafers 200 at a time. Further, in the above-described embodiments, an example in which a film is formed by using a substrate processing apparatus including a hot-wall-type process furnace is described. The present disclosure is not limited to the above-described embodiments and may also be suitably applied to, for example, a case in which a film is formed by using a substrate processing apparatus including a cold-wall-type process furnace.

Even in a case where these substrate processing apparatuses are used, each process may be performed according to the same processing procedures or under the same processing conditions as those of the above-described embodiments or modifications, and the same effects as those of the above-described embodiments or modifications are obtained.

The above-described embodiments or modifications may be used in combination as appropriate. The processing procedures and processing conditions in this case may be, for example, the same as those of the above-described embodiments or modifications.

According to the present disclosure in some embodiments, it is possible to improve coverage of a formed film.

While certain embodiments are described above, these embodiments are presented by way of example, and are not intended to limit the scope of the disclosure. Indeed, the embodiments described herein may be embodied in a variety of other forms. Furthermore, various omissions, substitutions and changes in the form of the embodiments described herein may be made without departing from the spirit of the disclosure. The accompanying claims and their equivalents are intended to cover such forms or modifications as would fall within the scope and spirit of the disclosure.

## Claims

1. A processing method, comprising:
a first process of modifying a predetermined surface of a material, by performing a first operation including:
(a1) supplying a precursor gas containing a first predetermined element and a halogen element to the material including the predetermined surface;
(a2) after (a1), supplying a first modifying gas containing oxygen to the material; and
(a3) after (a1), supplying a second modifying gas, which is different from the first modifying gas, to the material; and
a second process of forming a film containing the first predetermined element on the modified predetermined surface after the first process, by performing a second operation a predetermined number of times, the second operation including:
(b1) supplying the precursor gas to the material; and
(b2) supplying a reaction gas to the material.

2. The processing method of Claim 1, wherein the predetermined surface is a surface of a second predetermined material constituting the material, the second predetermined material containing a second predetermined element.

3. The processing method of Claim 2, wherein, in (a1), a first atomic group containing the second predetermined element and the first predetermined element and a second atomic group containing the second predetermined element and the halogen element are formed on at least a part of the predetermined surface, and
wherein, in (a2), the second atomic group is substituted with an OH group that bonds to the first predetermined element.

4. The processing method of any one of Claims 1 to 3, wherein the second modifying gas is a gas containing hydrogen, or
wherein the second modifying gas is an inert gas.

5. The processing method of any one of Claims 1 to 4, wherein, in (a2), the first modifying gas is continuously supplied.

6. The processing method of any one of Claims 1 to 4, wherein, in (a2), the first modifying gas is supplied in pulses.

7. The processing method of Claim 6, wherein, in (a2), the supply of the first modifying gas in pulses is performed a predetermined number of times.

8. The processing method of Claim 6, wherein, in (a2), the supply of the first modifying gas in pulses is performed a plurality of times, and an inert gas is supplied between the pulses, or
wherein in (a2), the supply of the first modifying gas in pulses is performed a plurality of times, and exhaust is performed between the pulses.

9. The processing method of any one of Claims 1 to 8, wherein the first operation further includes (a4) performing (a1) and (a2) a predetermined number of times, or
wherein the first operation further includes (a4) performing (a1) and (a2) a plurality of times.

10. The processing method of Claim 4, wherein (a2) and (a3) are performed a predetermined number of times.

11. The processing method of Claim 4, wherein (a3) and (a2) are supplied in this order.

12. The processing method of any one of Claims 1 to 11, wherein the first modifying gas contains hydrogen, or
wherein the first modifying gas contains hydrogen and in (a2), the material is not brought into contact with plasma.

13. A method of manufacturing a semiconductor device, comprising the processing method of Claim 1.

14. A program that causes, by a computer, a substrate processing apparatus (10), to perform:
a first process of modifying a predetermined surface of a material, by performing a first operation including:
(a1) supplying a precursor gas containing a first predetermined element and a halogen element to the material including the predetermined surface;
(a2) after (a1), supplying a first modifying gas containing oxygen to the material; and
(a3) after (a1), supplying a second modifying gas, which is different from the first modifying gas, to the material; and
a second process of forming a film containing the first predetermined element on the modified predetermined surface after the first process, by performing a second operation a predetermined number of times, the second operation including:
(b1) supplying the precursor gas to the material; and
(b2) supplying a reaction gas to the material.

15. A processing apparatus, comprising:
a gas supply system configured to supply, to a material including a predetermined surface, a precursor gas containing a first predetermined element and a halogen element, a first modifying gas containing oxygen, a second modifying gas different from the first modifying gas, and a reaction gas; and
a controller (121) configured to be capable of controlling the gas supply system so as to perform:
a first process of modifying the predetermined surface, by performing a first operation including:
(a1) supplying the precursor gas to the material;
(a2) after (a1), supplying the first modifying gas to the material; and
(a3) after (a1), supplying the second modifying gas to the material; and
a second process of forming a film containing the first predetermined element on the modified predetermined surface after the first process, by performing a second operation a predetermined number of times, the second operation including:
(b1) supplying the precursor gas to the material; and
(b2) supplying the reaction gas to the material.
